# EUROPEAN PATENT APPLICATION

(11) **EP 4 354 522 A1**
(43) Date of publication of application: **17.04.2024**
(21) Application number: 22820206.5
(22) Date of filing: 07.06.2022
(51) Int. Cl.: H01L 31/05, B32B 27/32, H01L 31/048

(54) **RESIN FILM FOR CURRENT COLLECTING SHEET, CURRENT COLLECTING SHEET, SOLAR CELL ELEMENT WITH CURRENT COLLECTING SHEET, AND SOLAR CELL**

(30) Priority: 07.06.2021 JP 2021095083
(71) Applicant: DAI NIPPON PRINTING CO., LTD., Tokyo 162-8001 (JP)
(72) Inventor: ARIHARA, Keita, Tokyo 162-8001 (JP); MURASAWA, Ken, Tokyo 162-8001 (JP); UENO, Shigehiro, Tokyo 162-8001 (JP)
(74) Representative: Beck Greener LLP
(86) International application number: PCT/JP2022/022897
(87) International publication number: WO 2022/260027

(57) **Abstract**

The present disclosure provides a resin film for a current collector sheet (10) to be used for a current collector sheet of a solar cell, the resin film for a current collector sheet (10) comprising: a heat-resistant layer (1) and a sealing layer (2) placed on one surface side of the heat-resistant layer (1), wherein the heat-resistant layer (1) includes polypropylene resin.

## Description

### Technical Field

The present disclosure relates to a film for a current collector sheet, a current collector sheet, a solar cell element with a current collector sheet and a solar cell.

### Background Art

In recent years, global warming caused by carbon dioxide has become a global problem. In response to this problem, solar cells that utilize solar energy are attracting attention as environmentally friendly and clean energy sources, and active research and development is being carried out.

Solar cells are used, for example, in the form of modules wherein a plurality of solar cell elements are connected.

As a method of connecting the solar cell elements to each other, for example, the method of connecting solar cell elements to each other using a band shaped conductor wire with a width of approximately 2 mm to 5 mm called a bus bar has been used conventionally. The connection method using the bus bar has a problem that sunlight is physically blocked in the area where the bus bar is placed in the solar cell module, which reduces the amount of sunlight injected into the solar cell element.

Meanwhile, in recent years, a method called multi-wire connection has been adopted, for example, in which a wire (fine line shaped conductor wire) with a diameter of approximately 150 um or more and 300 um or less is used to connect the solar cell elements to each other. In a multi-wire connection, examples of a method for fixing the wire to the solar cell element may include a method wherein a current collector sheet is obtained by embedding a wire into a thermally weldable resin film, and the wire is fixed by thermal compression bonding the current collector sheet to the solar cell element (Patent Documents 1 and 2).

### Citation List

### Patent Documents

Patent Document 1: WO2004/021455
Patent Document 2: WO2017/076735

### Summary of Disclosure

### Technical Problem

In recent years, there has been a demand for further improvement in the power generation efficiency and longer life of the solar cells. In accordance with the above, the resin film for a current collector sheet to be used for a multi-wire connection is required to have good ultraviolet transmittance and good ultraviolet resistance.

The present disclosure has been made in view of the above circumstances, and a main object of the present disclosure is to provide a resin film for a current collector sheet with good ultraviolet transmittance and good ultraviolet resistance; a current collector sheet and a solar cell element with a current collector sheet using the same; and a solar cell with a high light utilization efficiency.

### Solution to Problem

The present disclosure provides a resin film for a current collector sheet to be used for a current collector sheet of a solar cell, the resin film for a current collector sheet comprising: a heat-resistant layer and a sealing layer placed on one surface side of the heat-resistant layer, wherein the heat-resistant layer includes polypropylene resin.

Also, the present disclosure provides a current collector sheet to be used for a solar cell, the current collector sheet comprising: the resin film for a current collector sheet described above; and a wire placed on a sealing layer side surface of the resin film for a current collector sheet.

Also, the present disclosure provides a solar cell element with a current collector sheet comprising: the current collector sheet described above; and a solar cell element placed on a sealing layer side surface of the current collector sheet, and electrically connected to the wire.

Further, the present disclosure provides a solar cell comprising a transparent substrate, a first sealing material, the solar cell element with a current collector sheet described above, a second sealing material and counter substrate in this order.

### Advantageous Effects of Disclosure

The resin film for a current collector sheet in the present disclosure has effects that it has good ultraviolet transmittance and good ultraviolet resistance. Also, the solar cell in the present disclosure has an effect that light utilization efficiency is high.

### Brief Description of Drawings

FIG. 1 is a schematic cross-sectional view illustrating an example of a resin film for a current collector sheet in the present disclosure.
FIG. 2 is a schematic cross-sectional view illustrating an example of a resin film for a current collector sheet in the present disclosure.
FIGS. 3A and 3B are a schematic plan view and a schematic cross-sectional view illustrating an example of a current collector sheet in the present disclosure.
FIG. 4 is a schematic cross-sectional view illustrating an example of a current collector sheet in the present disclosure.
FIG. 5 is a schematic plan view illustrating an example of a current collector sheet in the present disclosure.
FIGS. 6A to 6C are a schematic perspective view and schematic cross-sectional views illustrating an example of a solar cell element with a current collector sheet in the present disclosure.
FIG. 7 is a schematic plan view illustrating an example of a solar cell in the present disclosure.

### Description of Embodiments

Embodiments in the present disclosure are hereinafter explained with reference to, for example, drawings. However, the present disclosure is enforceable in a variety of different forms, and thus should not be taken as is limited to the contents described in the embodiments exemplified as below. Also, the drawings may show the features of the present disclosure such as width, thickness, and shape of each part schematically comparing to the actual form in order to explain the present disclosure more clearly in some cases; however, it is merely an example, and thus does not limit the interpretation of the present disclosure. Also, in the present description and each drawing, for the factor same as that described in the figure already explained, the same reference sign is indicated and the detailed explanation thereof may be omitted.

When described as "on" or "below", unless otherwise stated, it includes both of the following cases: a case wherein some member is placed directly on or directly below the other member so as to be in contact with the other member, and a case wherein some member is placed on the upper side or the lower side of the other member via yet another member. Similarly, in the present descriptions, on the occasion of expressing an aspect wherein some member is placed "on the surface side of other member", unless otherwise stated, it includes both of the following cases: a case wherein some member is placed directly on the other member so as to be in contact with the surface of other member, and a case wherein some member is placed on the surface of the other member via yet another member.

Also, the terms such as "film", "sheet" and "plate" in the present descriptions are not distinguished from each other based on the difference in naming.

As described above, when a plurality of solar cell elements are connected by a multi-wire connection in a solar cell module, examples of a method for fixing the wire to the solar cell element may include a method wherein a current collector sheet including a resin film and a wire is thermal compression bonded to a solar cell element to fix the wire to the solar cell element. The resin film used for the current collector sheet is also called a connecting film. For example, as the resin film used for the current collector sheet, a resin film including a heat-resistant layer including polyethylene terephthalate resin (PET resin) and a sealing layer including polyolefin resin is widely used.

The melting point of the PET resin is approximately 260°C and the heat resistance is high. Also, with the PET resin, good stiffness may be obtained when formed into a film. Therefore, the current collector sheet including PET resin may press the wire against the solar cell element by the resin film during thermal compression bonding, so that the wire may be well fixed to the solar cell element. Meanwhile, the PET resin has poor ultraviolet transmittance and easily yellows by absorbing ultraviolet rays. Also, the PET resin is prone to a crack or a fracture due to damage from ultraviolet rays. For this reason, for the current collector sheet including PET resin, it is necessary to add an ultraviolet absorber to the sealing material that is placed on the outer side of the current collector sheet, for example, when it is incorporated into the solar cell.

By the way, solar cell elements with a configuration that is able to generate power even in the ultraviolet region of sunlight are widely used. Therefore, in view of the improvement of light utilization efficiency, the resin film of a current collector sheet to be used together with the solar cell element is required to have good ultraviolet transmittance and good ultraviolet resistance. Therefore, as a method for improving wherein ultraviolet resistance is imparted to the resin film including PET resin, methods for improving such as adding an additive are being studied. However, it is difficult to obtain a resin film with a desired ultraviolet transmittance and ultraviolet resistance.

In view of the above circumstances, the inventors of the present disclosure have carried out intensive studies, and found that, by using polypropylene resin (PP resin) instead of PET resin as the resin for the heat-resistant layer, a resin film having stiffness usable as a current collector sheet, with good ultraviolet transmittance and good ultraviolet resistance may be obtained, which led to the completion of the invention. A resin film, and a current collector sheet, a solar cell element with a current collector sheet and a solar cell using the same in the present disclosure are hereinafter described in detail.

Incidentally, in the present descriptions, "ultraviolet" means a ray with a wavelength of 400 nm or less. In the present descriptions, "ultraviolet" is a ray including a wavelength of 300 nm or more and 400 nm or less which is ultraviolet light in the solar spectrum of air mass 1.5.

### A. Resin film for current collector sheet

The resin film for a current collector sheet in the present disclosure is a resin film for a current collector sheet to be used for a current collector sheet of a solar cell, the resin film for a current collector sheet comprising: a heat-resistant layer and a sealing layer placed on one surface side of the heat-resistant layer, wherein the heat-resistant layer includes polypropylene resin.

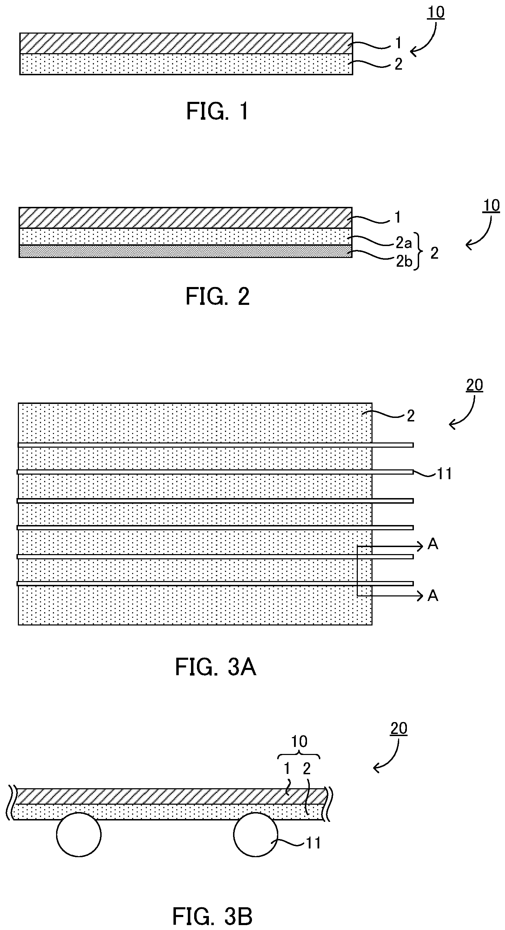

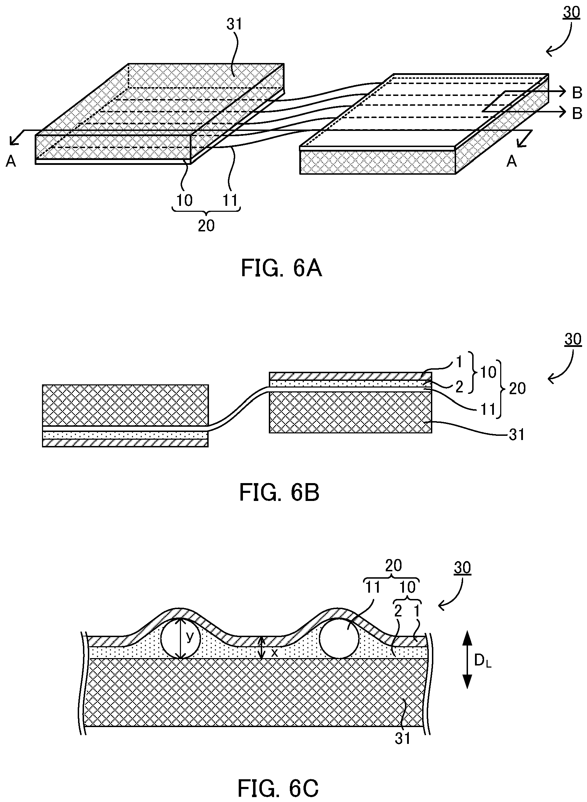

The resin film for a current collector sheet in the present disclosure is explained referring to the figures. FIG.1 is a schematic cross-sectional view illustrating an example of the resin film for a current collector sheet in the present disclosure. The resin film for a current collector sheet 10 shown in FIG. 1 includes a heat-resistant layer 1 and a sealing layer 2 placed on one surface side of the heat-resistant layer 1, and the heat-resistant layer 1 includes polypropylene resin. The resin film 10, together with a wire 11, constitutes a current collector sheet 20, as described in FIGS. 3A and 3B below. Also, as described in FIGS. 6A to 6C below, the resin film 10 is used to fix the wire 11 electrically connected to the solar cell element 31.

According to the present disclosure, since the heat-resistant layer includes polypropylene resin, a resin film has good ultraviolet transmittance and good ultraviolet resistance, and has stiffness usable for a current collector sheet. Further, since the resin film for a current collector sheet has stiffness, the heat shrinkage of the resin film for a current collector sheet may be suppressed and curl deformation may be suppressed, in the heating step such as fixing the wire to the solar cell element using the resin film for a current collector sheet.

### I. Constitution of resin film for current collector sheet

The resin film for a current collector sheet used in the present disclosure comprises at least a heat-resistant layer and a sealing layer.

### 1. Heat-resistant layer

The heat-resistant layer is a layer that imparts heat resistance to the resin film for a current collector sheet. Here, "heat resistance" refers to a durability against heat imparted in the production process of solar cells, such as fixing the wire to the solar cell element using the resin film for a current collector sheet; and heat in the environment of usage of the solar cell.

### (1) Properties of heat-resistant layer

The heat-resistant layer used in the present disclosure preferably has the following properties.

### (a) Melting point

The melting point of the resin constituting the heat-resistant layer is not particularly limited as long as it exhibits a desired heat resistance, and is, for example, 80°C or more, preferably 120°C or more, and more preferably 150°C or more. Also, the upper limit of the melting point of the resin constituting the heat-resistant layer is usually 200°C or less. This is because, when the melting point of the resin constituting the heat-resistant layer is too low, the resin film for a current collector sheet may be deteriorated significantly during the production process of the solar cell or the use of the solar cell. Also, when the melting point of the resin is too high, it may be difficult to form it into a film, and production costs may increase since it is necessary to rise the temperature to melt the resin during the production of resin film for a current collector sheet.

In the present disclosure, the melting point of the resin may be determined by differential scanning calorimetry (DSC) in accordance with the method for measuring transition temperature of plastics (JIS K7121:1987). Incidentally, in doing so, when there are two or more melting point peaks, the higher temperature is regarded as the melting point.

### (b) Storage elastic modulus

Also, the resin film for a current collector sheet in the present disclosure is placed in close contact with the solar cell element, as a current collector sheet, when it is used in the solar cell. In doing so, it is preferable that the resin film for a current collector sheet has stiffness to the extent that the wire is pressed against the solar cell element so as to connect thereof electrically. Such stiffness is given by the heat-resistant layer, so that the heat-resistant layer preferably has a predetermined stiffness.

Such stiffness may be evaluated, for example, by a storage elastic modulus. The storage elastic modulus of the heat-resistant layer at 150°C is, for example, 0.1 MPa or more and 1.0 GPa or less, and preferably 1.0 MPa or more and 100 MPa or less. When the storage elastic modulus is less than the above range, the stiffness of the heat-resistant layer is not sufficient, so that the stiffness as the resin film for a current collector sheet is also insufficient, and when the current collector sheet is placed on the solar cell element, a failure may occur that the contact between the wire and the solar cell element is not sufficient. Meanwhile, when the storage elastic modulus is higher than the above range, it may be necessary to apply a large pressure when placing the current collector sheet on the solar cell element, which may cause problems such as unnecessary costs such as increasing the size of the production equipment.

Here, the storage elastic modulus may be measured by dynamic mechanical analysis (DMA) by the method according to JIS K7244-4:1999. Specifically, at first, the resin film for a current collector sheet is cut into a desired size, then the sealing layer is peeled off from the resin film for a current collector sheet, or the sealing layer is scraped off from the resin film for a current collector sheet, to prepare a sample of the heat-resistant layer. Then, both ends of the sample are installed to the chuck of the dynamic mechanical analysis device so that the tensile direction is the longitudinal direction of the sample, and the measurement is carried out by a tensile method under a tensile load. For example, Rheogel-E4000 from UBM Corporation may be used as a dynamic mechanical analyzing device. The specific measurement conditions are shown below.

### (Measurement conditions of storage elastic modulus)

▪ Measurement sample: rectangle shape of 5 mm × 20 mm
▪ Measurement mode: tensile method (sine-wave distortion, tensile mode, strain amount: automatic strain)
▪ Temperature rising rate: 3°C/min
▪ Temperature: -60°C or more and 150°C or less
▪ Frequency: 10 Hz
▪ Tensile load (static load): 100 g

Incidentally, in the preparation of the sample of the heat-resistant layer, when peeling the sealing layer off from the resin film for a current collector sheet, for example, a peeling tester may be used. Specifically, the sealing layer may be peeled off from the resin film for a current collector sheet by fixing a resin film for a current collector sheet of a predetermined size to a peeling tester, after imparting a trigger to peel off at the interface of the heat-resistant layer and the sealing layer, and then, pulling the sealing layer.

For example, the storage elastic modulus of the heat-resistant layer at 150°C may be adjusted by, for example, the type of polypropylene resin included in the heat-resistant layer; the addition of materials other than polypropylene resin; and the material composition. For example, the storage elastic modulus may be increased by adding a filler.

### (c) Ultraviolet transmittance

The heat-resistant layer in the present disclosure includes polypropylene resin as described above, and has better ultraviolet transmittance than that of conventional ones using PET resin.

The ultraviolet transmittance of the heat-resistant layer may be evaluated by, for example, the transmittance of light with a wavelength of 350 nm. The transmittance, of light with a wavelength of 350 nm, of the heat-resistant layer is preferably, for example 75% or more, more preferably 80% or more, and further preferably 85% or more. Since the transmittance, of light with a wavelength of 350 nm, of the heat-resistant layer used in the present disclosure is high, when the resin film for a current collector sheet in the present disclosure is used in the solar cell element, the ultraviolet region may contribute to the power generation of the solar cell element.

Here, the transmittance of light with a wavelength of 350 nm may be measured, for example, using a spectrophotometer. Incidentally, when measuring the transmittance, of light with a wavelength of 350 nm, of the heat-resistant layer, a measurement sample is prepared and used for the measurement. The measurement sample is prepared by stacking a sealing material sheet including olefin resin ("CVF2SS" from Dai Nippon Printing Co., Ltd.) with a thickness of 450 um on one surface of the heat-resistant layer, and vacuum laminating under the conditions of setting temperature of 150°C, vacuum evacuation for 5 minutes, pressurization under atmospheric pressure for 9 minutes and pressure of 100 kPa.

### (2) Composition of heat-resistant layer

The composition of the heat-resistant layer used in the present disclosure includes polypropylene resin, and if necessary, for example, a light stabilizer, and an adhesion improving agent improving the close adhesiveness to the sealing layer, may be included.

### (a) Polypropylene resin

The heat-resistant layer includes at least polypropylene resin.

Such polypropylene resin may be, for example, homopolypropylene resin (homo PP) that is a propylene monopolymer; may be random polypropylene resin (random PP) that is a random copolymer of propylene and α-olefin; and may be block polypropylene resin (block PP) that is a block copolymer. The heat-resistant layer may include one kind alone or two kinds or more of the various polypropylene resins described above.

Among them, in the present disclosure, the polypropylene resin is preferably homopolypropylene resin. This is because, since the homopolypropylene resin has high stiffness, the wire may be easily fixed to the solar cell element by using the resin film for a current collector sheet.

Also, the heat-resistant layer in the present disclosure may include only polypropylene resin as the resin, and other resins may be included such that polypropylene resin is the main component. Here, polypropylene resin being the main component means that the proportion of polypropylene resin, among all the resin components, is the highest.

The proportion of the polypropylene resin with respect to all the resin components in the heat-resistant layer is, for example, 50% by mass or more, may be 60% by mass or more, may be 65% by mass or more, and may be 70% by mass or more. Also, the proportion of the polypropylene resin is 100% by mass or less, may be 90% by mass or less, may be 80% by mass or less, and may be 75% by mass or less.

When the polypropylene resin is homopolypropylene resin, the proportion of the homopolypropylene resin with respect to all the resin components in the heat-resistant layer is preferably, for example, 50% by mass or more and 90% by mass or less. This is because, when the proportion of homopolypropylene resin is too low, it is difficult to impart a desired heat resistance to the resin film for a current collector sheet. Meanwhile, since homopolypropylene resin is less transparent than random polypropylene resin, for example, the transparency of the resin film for a current collector sheet may be decreased, when the proportion of homopolypropylene resin is too high.

Incidentally, the proportion of each resin component included in each layer of the resin film for a current collector sheet may be analyzed from the ratio of the detected peaks by, for example, a differential scanning calorimetry (DSC), an infrared spectroscopy (IR) and a nuclear magnetic resonance (NMR).

### (b) Light stabilizer

The heat-resistant layer in the present disclosure may include a light stabilizer. This is because the deterioration of the heat-resistant layer due to ultraviolet may further be suppressed when the heat-resistant layer includes the light stabilizer. As the light stabilizer, for example, a hindered amine based light stabilizer (HALS) is preferably used.

The hindered amine based light stabilizer is not particularly limited as long as it is able to exhibit light stabilizing effect, and for example, a high molecular weight type light stabilizer including a molecular structure of a copolymer of ethylene and cyclic aminovinyl compound (hindered amine based acrylate), with a molecular weight of 30000 or more, may be preferably used.

Specific examples of the high molecular weight type light stabilizer may include a copolymer of ethylene and a cyclic aminovinyl compound (hindered amine based acrylate) represented by Chemical formula (1) below.

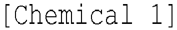

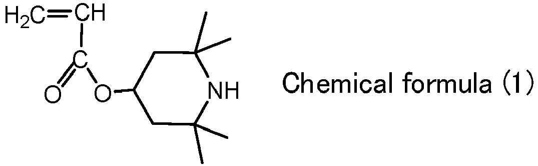

Examples of the high molecular weight type hindered amine based light stabilizer may include "XJ-100H (trade name)" (molecular weight: 35000) from Japan Polyethylene Corporation.

Also, other examples of the hindered amine based light stabilizer may include a NOR type hindered amine based light stabilizer. An example of the NOR type hindered amine based light stabilizer is a compound including a group represented by the General formula (1).

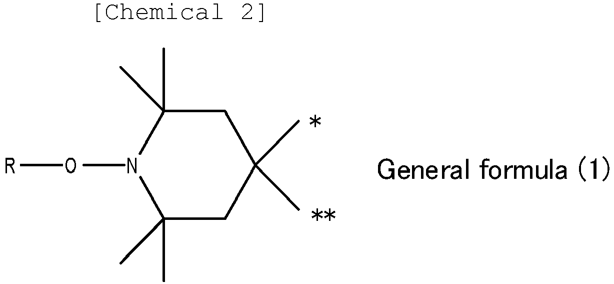

In the General formula (1), R is a substituted or non-substituted hydrocarbon group or acyl group. Examples of R may include an alkyl group, an alkenyl group, an alkylene group, a cycloalkyl group, a bicycloalkyl group, a phenyl group, a naphthyl group, a phenylalkyl group, an alkyl group substituted phenyl group, a hydroxyl group substituted alkyl group, an acyl group, an alkoxy substituted alkyl group and a thioalkoxy group substituted alkyl group. Incidentally, * and ** in the General formula (1) indicate the state being able to be bonded with another element.

Other examples of the NOR type hindered amine based light stabilizer may include a compound represented by the General formula (2) or General formula (3).

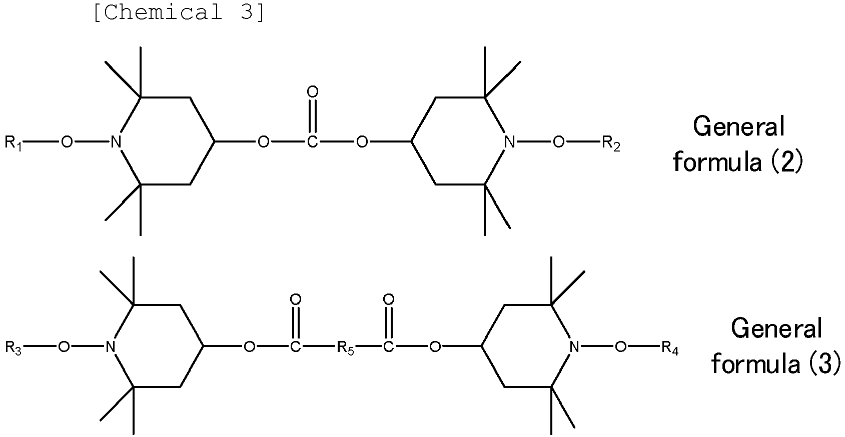

In the General formula (2), R₁ and R₂ each independently represents a substituted or non-substituted hydrocarbon group or acyl group, as similar to R in the General formula (1) described above. Among the above, it is preferable that R₁ and R₂ each independently represents an alkyl group with a carbon number of 4 or more and 20 or less.

In the General formula (3), R₃ and R₄ each independently represents a substituted or non-substituted hydrocarbon group or acyl group, as similar to R in the General formula (1) described above. Among the above, it is preferable that R₃ and R₄ each independently represents an alkyl group with a carbon number of 4 or more and 20 or less. Also, R₅ represents an alkylene group with a carbon number of 1 or more and 8 or less.

Specific examples of the NOR type hindered amine based light stabilizer may include "ADK STAB LA-81 (trade name)" from ADEKA Corporation; "Tinuvin 123 (trade name)" (decanedioic acid bis(2,2,6,6-tetramethyl-1-(octyloxy)-4-piperidinyl)ester) from BASF Japan Ltd.; and "Tinuvin XT850FF (trade name)" from BASF Japan Ltd.

The proportion of the light stabilizer with respect to total solid content in the heat-resistant layer is, for example, 3% by mass or more and 10% by mass or less, preferably 3.5% by mass or more and 4.5% by mass or less. By making the proportion of the light stabilizer in the above range, the ultraviolet resistance of the resin film for a current collector sheet may further be improved. Meanwhile, when the proportion of the light stabilizer is too high, the transparency of the heat-resistant layer may be decreased due to the bleed-out of the light stabilizer; or the close adhesiveness between the heat-resistant layer and the sealing layer may be decreased.

### (c) Adhesion improving agent

The heat-resistant layer in the present disclosure may include adhesion improving agent to improve close adhesiveness with the sealing layer, especially close adhesiveness when the sealing layer includes polyethylene resin.

Examples of such adhesion improving agent may include polyethylene based elastomers and polyethylene based plastomers. In the present disclosure, by the polyethylene based elastomer or polyethylene based plastomer being included in the heat-resistant layer, not only the close adhesiveness with the sealing layer may be improved, but also the durability of the resin film for a current collector sheet may be improved.

Examples of the polyethylene based elastomer and polyethylene based plastomer may include a copolymer of ethylene and α-olefin other than ethylene (hereinafter may be referred to as an ethylene-α-olefin copolymer in some cases).

The polyethylene constituting the ethylene-α-olefin copolymer is not particularly limited, and is preferably low-density polyethylene. Also, as the low-density polyethylene, for example, the low-density polyethylene with a density of 0.870 g/cm³ or more and 0.910 g/cm³ or less is preferable. The density of the polyethylene may be measured by a method according to JIS K7112:1999.

Examples of the α-olefin constituting the ethylene-α-olefin copolymer may include an α-olefin with a carbon number of 3 or more and 20 or less. Specific examples thereof may include propylene, 1-butene, 4-methyl-1-pentene, 3-methyl-1-butene, 1-pentene, 1-hexene, 1-heptene, 1-octene, 1-nonene, 1-decene, 1-undecene, and 1-dodecene. One kind or two kinds or more of these are used.

For the ethylene-α-olefin copolymer, for example, a commercially available product may be used. Examples of the commercially available product may include "TAFMER DF-710 (trade name)", "TAFMER DF-119 (trade name)", "TAFMER DF-110 (trade name)", "TAFMER A-1085S (trade name)", "TAFMER A-4070S (trade name)", "TAFMER A-4085S (trade name)", and "TAFMER A-4090S (trade name)" from Mitsui Chemicals, Inc. Examples thereof may also include "Metallocene Polyethylene KN KF260T (trade name)", "Metallocene Polyethylene KN KF270 (trade name)", "Metallocene Polyethylene KN KF370 (trade name)", "Metallocene Polyethylene KN KF360T (trade name)", "Metallocene Polyethylene KN KS240T (trade name)", "Metallocene Polyethylene KN KS340T (trade name)", and "Metallocene Polyethylene KN KS260 (trade name)" from Japan Polyethylene Corporation. Examples may further include "Excellen VL100 (trade name)", "Excellen VL102 (trade name)", "Excellen VL200 (trade name)", "Excellen FX201 (trade name)", "Excellen FX301 (trade name)", "Excellen FX307 (trade name)", "Excellen FX351 (trade name)", "Excellen FX352 (trade name)" and "Excellen FX357 (trade name)" from SumitomoChemical Co. Ltd.

The proportion of the adhesion improving agent with respect to all the resin components in the heat-resistant layer is, for example, 5% by mass or more, may be 10% by mass or more, and may be 15% by mass or more. Also, the proportion of the adhesion improving agent is, for example, less than 50% by mass, may be 40% by mass or less, may be 30% by mass or less, and may be 20% by mass or less. This is because the transparency of the resin film for a current collector sheet may be decreased, when the proportion of adhesion improving agent is too high. Also, this is because, a desired heat resistance may not be imparted to the resin film for a current collector sheet.

### (d) Others

The heat-resistant layer in the present disclosure may include a polypropylene based elastomer (PP based elastomer). By including the polypropylene based elastomer, the transparency of the heat-resistant layer may be improved.

Examples of the polypropylene based elastomer may include a copolymer of propylene and α-olefin other than propylene (hereinafter may be referred to as a propylene-α-olefin copolymer in some cases).

Examples of the α-olefin constituting the propylene-α-olefin copolymer may include an α-olefin with a carbon number of 2 or 4 or more and 20 or less. Specific examples thereof may include ethylene, 1-butene, 4-methyl-1-pentene, 1-pentene, 1-hexene, 1-heptene, 1-octene, 1-decene, 1-dodecene, 1-tetradecene, 1-hexadecene, 1-octadecene and 1-eicosene. One kind or two kinds or more of these are used.

Among them, the propylene-α-olefin copolymer is preferably a copolymer of propylene, ethylene and α-olefin other than propylene and ethylene.

For the propylene-α-olefin copolymer, for example, a commercially available product may be used. Examples of the commercially available product may include TAFMER PN-3560 (trade name), TAFMER PN-0040 (trade name), and TAFMER PN-2060 (trade name) from Mitsui Chemicals, Inc.

The proportion of the polypropylene based elastomer with respect to all the resin components in the heat-resistant layer is, for example, 5% by mass or more, may be 10% by mass or more, and may be 15% by mass or more. Also, the proportion of the polypropylene base elastomer is, for example less than 50% by mass, may be 40% by mass or less, may be 30% by mass or less, and may be 20% by mass or less. This is because, when the proportion of the polypropylene based elastomer is less than the above range, the effect of improving the transparency of the resin film for a current collector sheet may not be obtained. Also, this is because, when the proportion of the polypropylene based elastomer is more than the above range, a desired heat resistance may not be imparted to the resin film for a current collector sheet.

### (3) Others

The thickness of the heat-resistant layer may be appropriately selected according to the size or use application of the solar cell in which the resin film for a current collector sheet is used and is not particularly limited. For example, the thickness is 10 um or more, may be 15 um or more, and may be 20 um or more. Also, the thickness of the heat-resistant layer is, for example, 50 um or less, may be 45 um or less, and may be 40 um or less.

### 2. Sealing layer

The sealing layer in the present disclosure is a layer which is thermally weldable, and configured to support the wire when used in the current collector sheet.

The resin used for the sealing layer is usually thermally weldable resin. Also, the resin used for the sealing layer preferably has a property to wrap around the wire when the current collector sheet is thermal compression bonded to the solar cell element. Hereinafter, the property described above may be described by referring to as a molding property.

A close adhesiveness to the heat-resistant layer and a close adhesiveness to the wire, which is a metal material, are required to the sealing layer. Such a sealing layer may be constituted with a single layer, and may be constituted with a multilayer. The present embodiment is hereinafter described by dividing thereof into the following cases: a case wherein the sealing layer is a single layer, and a case wherein the sealing layer is a multilayer.

### (1) Case where sealing layer is single layer

When the sealing layer is a single layer, the sealing layer usually includes resin with thermally welding properties and molding properties. Examples of such resin may include thermoplastic resin. From the viewpoint of ultraviolet transmittance or visible light transmittance, polyolefin resins and ionomer resins are preferably used as the thermoplastic resin. Among them, in the present disclosure, the polyolefin resin is preferable. Hereinafter, the polyolefin resin is described in detail.

### (a) Polyolefin resin

The melting point of the polyolefin resin used for the sealing layer is not particularly limited as long as it is able to exhibit the desired thermally welding properties and molding properties. The melting point of the polyolefin resin is, for example, 125°C or less, may be 120°C or less, and may be 110°C or less. Also, the melting point of the polyolefin resin is, for example, 80°C or more. This is because, when the melting point of the polyolefin resin is too high, the production costs may increase and the solar cell element may be deteriorated, since it is necessary to rise the temperature when the current collector sheet is thermal compression bonded to the solar cell element. Meanwhile, this is because, when the melting point of the polyolefin resin is too low, the sealing layer may melt in the solar cell usage environment, making it difficult to fix the wire.

Among the polyolefin resin, in the present disclosure, polyethylene resin and polypropylene resin are preferable, and polyethylene resin is particularly preferable. This is because it has excellent molding properties.

Examples of the polyethylene resin may include high density polyethylene (HDPE), linear low density polyethylene (LLDPE), low density polyethylene (LDPE), very low density polyethylene (VLDPE). One kind of these may be used alone, and two kinds or more may be used in combination. Among them, in the present disclosure, the linear low density polyethylene (LLDPE) is preferable. The close adhesiveness between the heat-resistant layer and the sealing layer may be improved.

The density of the polyethylene resin is not specifically limited, and it is preferably, for example, 0.890 g/cm³ or more and 0.930 g/cm³ or less, and more preferably 0.900 g/cm³ or more and 0.925 g/cm³ or less. The density of the polyethylene resin may be measured by a pycnometry according to JIS K7112:1999.

Also, the sealing layer preferably includes the polyethylene based elastomer or polyethylene based plastomer described above, as the polyolefin resin.

The sealing layer may include only the polyolefin resin described above, and in addition to the polyolefin resin, it may further include resins other than the polyolefin resin. In the latter case, the sealing layer preferably includes the polyolefin resin as the main component. The polyolefin resin being the main component means that the proportion of the polyolefin resin, among all the resin components, is the highest.

The proportion of the polyolefin resin with respect to all the resin components in the sealing layer is, for example, 50% by mass or more, may be 60% by mass or more, and may be 70% by mass or more. Also, the proportion of the polyolefin resin is, for example, 99% by mass or less, may be 95% by mass or less, and may be 90% by mass or less. The proportion of the polyolefin resin may be 100% by mass.

Also, when the polyethylene based elastomer or polyethylene based plastomer described above is included as the polyolefin resin, the proportion of the polyolefin resin with respect to all the resin components in the sealing layer is preferably, for example, 90% by mass or more and 100% by mass or less. This is because the close adhesiveness between the heat-resistant layer and the sealing layer may be particularly improved, and the durability of the resin film for a current collector sheet may be improved. Also, the heat shrinkage of the resin film for a current collector sheet may be suppressed and curl deformation may be suppressed, in the heating step such as fixing the wire to the solar cell element using the resin film for a current collector sheet.

### (b) Light stabilizer

The sealing layer in the present disclosure is not particularly limited as long as it includes thermoplastic resin, and other components may be appropriately selected and added as necessary. Examples of such component may include a light stabilizer. Since the light is similar to the contents described in the section "1. Heat-resistant layer, (2) Composition of heat-resistant layer, (b) Light stabilizer" above, the explanation is omitted herein.

The proportion of the light stabilizer with respect to total solid content in the sealing layer is, for example, 0.2% by mass or more and 5% by mass or less, preferably 0.5% by mass or more and 3% by mass or less.

### (c) Adhesive improving agent

Also, the sealing layer in the present disclosure may include a component that improve adhesion to the wire or solar cell element.

Examples of such component may include silane-modified polyethylene resin. The silane-modified polyethylene resin is a silane copolymer wherein α-olefin and ethylenically unsaturated silane compound are copolymerized as comonomers. In the present disclosure, the silane-modified polyethylene resin is preferably resin obtained by graft polymerizing linear low density polyethylene (LLDPE) as the main chain and ethylenically unsaturated silane compound as the side chain.

Examples of the ethylenically unsaturated silane compounds may include vinyltrimethoxysilane, vinyltriethoxysilane, vinyltripropoxysilane, vinyltriisopropoxysilane, vinyltributoxysilane, vinyltripentyroxysilane, vinyltriphenoxysilane, vinyltribenzyloxysilane, vinyltrimethylenedioxysilane, vinyltriethylenedioxysilane, vinylpropionyloxysilane, vinyltriacetoxysilane, and vinyltricarboxysilane.

The silane-modified polyethylene resin may be obtained, for example, by the method for producing described in Japanese Patent Application Laid-Open (JP-A) No. 2003-46105.

The proportion of the silane-modified polyethylene resin with respect to all the resin components in the sealing layer is not particularly limited, and is preferably, for example, 5% by mass or more and 25% by mass or less. Also, the graft amount that is the content of the ethylenically unsaturated silane compound is preferably, for example, 0.001 parts by mass or more and 15 parts by mass or less, with respect to 100 parts by mass of all the resin components in the sealing layer.

### (2) Case where sealing layer is multilayer

The sealing layer may be a multilayer wherein a plurality of resin layers are stacked. When the sealing layer is a multilayer, as shown in FIG. 2 for example, the sealing layer 2 preferably includes a substrate layer 2a placed on the heat-resistant layer 1 side surface and an adhesive layer 2b placed on the substrate layer 2a, on the opposite side surface to the heat-resistant layer 1.

In the present disclosure, the adhesive improving agent described above is preferably added to the adhesive layer. By adding the adhesive improving agent described above to the adhesive layer, since the used amount of the adhesive improving agent may be reduced, the production cost of the resin film for a current collector sheet may be reduced.

Since the resin and additional components used in the substrate layer and adhesive layer may be similar to the contents described in the section "(1) Case where sealing layer is single layer" above, the explanation is omitted herein.

### (3) Others

The thickness of the sealing layer in the present disclosure is not particularly limited as long as it is able to support the wire when it is used in a current collector sheet, and may be appropriately selected according to the thickness of the wire. The thickness of the sealing layer is, for example, 10 um or more, may be 20 um or more, may be 50 um or more, and may be 65 um or more. Also, the thickness of the heat-resistant layer is, for example, 170 um or less, may be 100 um or less, may be 45 um or less, and may be 40 um or less.

### 3. Intermediate layer

In the resin film for a current collector sheet in the present disclosure, an intermediate layer may be placed between the heat-resistant layer and the sealing layer. Examples of the intermediate layer may include an adhesive agent layer including an adhesive configured to adhere the heat-resistant layer and the sealing layer. Examples of the adhesive may include an adhesive used for adhering a commonly used film. The thickness of the intermediate layer is not particularly limited as long as it is to the extent that the transparency of the resin film for a current collector sheet is not overly impaired.

Also, when the heat-resistant layer includes polypropylene resin, and the sealing layer includes polyethylene resin, a layer of a composition wherein polypropylene resin and polyethylene resin are mixed, may be provided as the intermediate layer.

### 4. Others

The interlayer adhesive strength between the heat-resistant layer and the sealing layer is preferably, for example 1.0 N/15 mm or more, more preferably 2.0 N/15 mm or more, and further preferably 5.0 N/15 mm or more. This is because, by the interlayer adhesive strength being the value described above or more, the close adhesiveness between the heat-resistant layer and the sealing layer may be improved so that peeling of the two layers may be effectively suppressed.

The interlayer adhesive strength may be measured, for example, by the following measurement method. The resin film for a current collector sheet is cut into a size of 15 mm width × 100 mm length to prepare a sample. A trigger to peel off is imparted between the heat-resistant layer and the sealing layer of the obtained sample. Then, a peeling test is carried out by holding 10 mm of the top and bottom of a peeling tester (Tensilon Universal Material Testing Instrument RTF-1150-H from A & D Co. Ltd.) with jigs, and under the conditions of a distance between chucks of 30 mm and a pulling rate of 50 mm/min., so as to measure the force required for peeling between the layers as an adhesive strength.

Also, the total thickness of the resin film for a current collector sheet in the present disclosure may be selected as appropriate according to the thickness of the wire used when used in a current collector sheet, and it is not particularly limited. For example, the total thickness may be 50 um or more and 200 um or less. This is because, when the resin film for a current collector sheet is too thin, it may be difficult to fix the wire sufficiently to the solar cell element. Meanwhile, when the resin film for a current collector sheet is too thick, the transparency may be decreased.

In the resin film for a current collector sheet, the thickness of the heat-resistant layer and the sealing layer may be selected as appropriate according to, for example, the thickness of the wire used when used in a current collector sheet, an arrangement and the embodiment of the solar cell element in which the current collector sheet is placed, and it is not particularly limited. The ratio of the thickness of the sealing layer with respect to the thickness of the heat-resistant layer (thickness of the sealing layer/thickness of the heat-resistant layer) is, for example, 0.1 or more and 2.4 or less, preferably 0.2 or more and 2.0 or less, and more preferably 0.4 or more and 1.8 or less. By setting the ratio of the thickness of the sealing layer with respect to the thickness of the heat-resistant layer in the above range, when the layers are placed on the solar cell element as the current collector sheet, the wire may be well fixed to the solar cell element.

### II. Physical properties of resin film for current collector sheet

### 1. Ultraviolet transmittance

The ultraviolet transmittance of the resin film for a current collector sheet in the present disclosure is not particularly limited as long as it is able to transmit the ultraviolet region to the extent that the solar cell element is able to generate electricity. The ultraviolet transmittance of the resin film for a current collector sheet may be evaluated by, for example, the transmittance of light with a wavelength of 350 nm. The transmittance, of light with a wavelength of 350 nm, of the resin film for a current collector sheet is preferably, for example 76% or more, more preferably 80% or more, and further preferably 85% or more. Since the transmittance, of light with a wavelength of 350 nm, of the resin film for a current collector sheet in the present disclosure is high, the ultraviolet region of sunlight may contribute to the power generation of the solar cell element.

Here, the transmittance of light with a wavelength of 350 nm may be measured, for example, using a spectrophotometer. Incidentally, when measuring the transmittance, of light with a wavelength of 350 nm, of the resin film for a current collector sheet, a measurement sample is prepared and used for measurement. The measurement sample is prepared by stacking a sealing material sheet including olefin resin ("CVF2SS" from Dai Nippon Printing Co., Ltd.) with a thickness of 450 um on the heat-resistant layer side surface of the resin film for a current collector sheet, vacuum laminating under the conditions of setting temperature of 150°C, vacuum evacuation for 5 minutes, pressurization under atmospheric pressure for 9 minutes and pressure of 100 kPa. Incidentally, since the resin film for a current collector sheet in the present disclosure has good ultraviolet resistance, UV-through type sealing material ("CVF2SS" from Dai Nippon Printing Co., Ltd.) is used as the sealing material sheet. However, when the resin film for a current collector sheet is inferior in ultraviolet resistance, UV-cutting type sealing material, for example, "CVF" from Dai Nippon Printing Co., Ltd. is used as the sealing material sheet. As the spectrophotometer, for example, an ultraviolet-visible and near-infrared spectrophotometer V-670 from JASCO Corporation may be used.

### 2. Total light transmittance

Also, the total light transmittance of the resin film for a current collector sheet is not particularly limited as long as it is able to transmit sunlight to the extent that the solar cell element is able to generate electricity. The total light transmittance of the resin film for a current collector sheet is, for example 75% or more, preferably 80% or more, and more preferably 85% or more. Since the total light transmittance is in the above range, the light utilization efficiency in the solar cell element may be increased. The total light transmittance is measured according to JIS K7361-1:1997. The total light transmittance may be measured with, for example, a haze meter HM150 from Murakami Color Research Laboratory Co., Ltd.

### 3. Transparency

The transparency of the resin film for a current collector sheet in the present disclosure is not particularly limited as long as it is able to transmit sunlight to the extent that the solar cell element is able to generate electricity. The transparency of the resin film for a current collector sheet may be evaluated, for example, by haze. The haze of the resin film for a current collector sheet is, for example, 1% or more and 20% or less, may be 2% or more and 150 or less, and may be 3% or more and 8% or less. The haze is measured according to JIS K7136:2000.

Here, the haze may be measured with, for example, a haze meter HM150 from Murakami Color Research Laboratory Co., Ltd. Incidentally, when measuring the haze of the resin film for a current collector sheet, a measurement sample is prepared and used for measurement. The measurement sample is prepared by the following method. Firstly, the resin film for a current collector sheet is cut into a size of 50 mm × 50 mm to prepare a test piece. Then, an ETFE (tetrafluoroethylene-ethylene copolymer) film, the test piece, and an ETFE film are stacked in this order, a vacuum lamination is carried out under conditions of setting temperature of 165°C, vacuum evacuation for 2 minutes, pressing for 2.5 minutes and pressure of 100 kPa. This is to eliminate fine irregularities on the surface of the resin film for a current collector sheet at the film formation stage. The ETFE films are then removed respectively from both surfaces of the test piece to prepare a measurement sample.

### 4. Slope of TMA curve

In the resin film for a current collector sheet in the present disclosure, the slope of the TMA curve defined below, at the temperatures between 90°C and 100°C, is preferably -3.0 or more and -1.3 or less.

In this case, the behavior of the material resin during thermal lamination process when being integrated as a solar cell module is optimized, and the compatibility of heat resistance and molding properties may be further stably exhibited in the production process of general solar cell modules.

Here, the "slope of TMA curve" in the present descriptions is defined as follows.
"Slope of TMA curve"
: In the "TMA curve" obtained by the "thermomechanical analysis (TMA) test" below, when the penetration depth at temperature X1 (°C) is Y1 (µm), and the penetration depth at temperature X2 (°C) (>X1 (°C)) is Y2 (pm), "slope (a) of TMA curve" between X1 and X2 means the value of (a) represented by (a) = (Y2 - Y1)/(X2 - X1). However, when the penetration depth reaches -150 um before the temperature reaches X2 (when a needle penetrates through the film being measured), the temperature X2 is replaced with the temperature at which the penetration depth reaches -150 µm.

Also, "thermomechanical analysis (TMA) test" described above refers to the test carried out under the following conditions.
"Thermomechanical analysis (TMA) test"
: A resin film for a current collector sheet with a thickness of 150 um is set on a thermomechanical analysis (TMA) test device, and the penetration depth of a needle of φ1 mm, when the needle is pressed at a constant pressing pressure of 100 kPa, and the temperature is raised from room temperature to 150°C at a temperature rising rate of 5°C/min, is measured. In doing so, the needle is pressed from the sealing layer side surface of the resin film for a current collector sheet.

Also, the "TMA curve" obtained by the thermomechanical analysis (TMA) test refers to a curve indicating the correlation between the temperature and the needle penetration depth in the thermomechanical analysis (TMA) test, in an XY coordinate when the temperature is X and the needle penetration depth at that temperature is Y.

As thermomechanical analysis (TMA) test device, for example, TMA/SS7100 from Hitachi High-Tech Science Corporation (former SII Nano Technology Inc.) and so on may be used.

By setting the slope of the TMA curve as defined above to -3.0 or more, during thermal lamination process when being integrated as a solar cell module, the resin film for a current collector sheet exhibits sufficient molding properties such that it adheres closely to the solar cell element, following the outer shape of the wire on the same surface side, on the sealing layer side surface of the resin film for a current collector sheet.

Meanwhile, by setting the slope of this TMA curve to -1.3 or less, during the thermal lamination process, excess resin flow is suppressed as the whole resin film for a current collector sheet. Thereby, the wire may be suppressed from penetrating through the resin film for a current collector sheet and being exposed from the heat-resistant layer side surface.

### III. Method for producing

The method for producing a resin film for a current collector sheet in the present disclosure is not particularly limited as long as it is possible to obtain the resin film for a current collector sheet wherein each of the layers described above is stacked, and examples thereof may include a method wherein a resin composition for forming each of the layers described above is prepared, and the resin compositions are melt molded. As the melt molding method, well-known molding methods may be used, and examples thereof may include injection molding, extrusion molding, hollow molding, compression molding and rotary molding. The temperature conditions at the time of molding are, for example, the melting point of the resin composition or more, and the upper limit is appropriately adjusted according to the type of resin composition.

In the method for producing a resin film for a current collector sheet, for example, the heat-resistant layer and the sealing layer may be molded respectively as separate films, and then, the two may be joined via an adhesive; or for example, a stacked film wherein the heat-resistant layer and the sealing layer are stacked may be molded by co-extrusion method, and the latter is preferable. This is because the close adhesiveness between the heat-resistant layer and the sealing layer may be improved, and the resin film for a current collector sheet may be produced with a high production efficiency.

### B. Current collector sheet

The current collector sheet in the present disclosure is a current collector sheet to be used for a solar cell, and comprises the resin film for a current collector sheet described in "A. Resin film for current collector sheet" above, and a wire placed on the sealing layer side surface of the resin film for a current collector sheet.

The current collector sheet in the present disclosure is explained referring to the figures. FIG. 3A is a schematic plan view illustrating an example of the current collector sheet in the present disclosure; and FIG. 3B is an A-A line cross-sectional view of FIG. 3A. The current collector sheet shown in FIGS. 3A to 3B comprises the resin film for a current collector sheet 10; and a wire 11 placed on the sealing layer 2 side surface of the resin film for a current collector sheet 10. Incidentally, FIG. 3A shows a schematic plan view of the current collector sheet viewed from the sealing layer side of the resin film for a current collector sheet.

According to the present disclosure, by including the resin film for a current collector sheet in the present disclosure described in "A. Resin film for current collector sheet" above, the wire may be in contact with the solar cell element under a sufficient stress, and the current collector sheet may exhibit good ultraviolet transmittance and good ultraviolet resistance.

### I. Structure of current collector sheet

The current collector sheet includes a resin film for a current collector sheet and a wire.

### 1. Resin film for current collector sheet

The resin film for a current collector sheet is a member configured to support the wire. Also, the resin film for a current collector sheet exhibits thermally welding properties to the solar cell element and is a member configured to fix the wire to the solar cell element. Since the resin film for a current collector sheet may be similar to the contents described in the section "A. Resin film for current collector sheet" above, the explanation is omitted herein.

As explained in "II. Structure of current collector sheet" below, when the current collector sheet includes a plurality of the resin films for a current collector sheet, at least one of the resin films for a current collector sheet may be the resin film for a current collector sheet in the present disclosure, and other resin film for a current collector sheet may be included. However, all of the plurality of the resin films for a current collector sheet included in the current collector sheet are preferably the resin film for a current collector sheet in the present disclosure.

### 2. Wire

The wire is placed on the sealing layer side surface of the resin film for a current collector sheet. The wire is used, for example, to connect solar cell elements to each other in a solar cell module. Also, the wire is used, for example, to collect electricity generated by the solar cell element in a single cell type solar cell. The wire is usually placed so as to be connected with the electrode of the solar cell element.

The cross-sectional shape of the wire is typically, but not limited thereto, circular shape such as a true circular shape and an elliptical shape.

The thickness of the wire, that is, the size of the cross-section of the wire is not particularly limited as long as it does not block the incident of sunlight to the solar cell element, and is, for example, 100 um or more and 200 um or less. The size of the cross-section of the wire refers to, for example, diameter when the cross-sectional shape is a circular shape; a major diameter when the cross-sectional shape is an elliptical shape; and a distance of the maximum diagonal line when the cross-sectional shape is a polygonal shape.

The material of the wire is not particularly limited as long as it is capable of exhibiting a desired conductivity, and it may be similar to the material of the wire used for the current collector sheet of a commonly used solar cell element. For example, metal material such as copper (Cu) and silver (Ag) may be used as the material of the wire.

Also, the wire may include, for example, a core portion and an epidermis portion placed on the outer side of the core portion. In this case, for example, the metal material described above may be used as the material of the core portion, and solder may be used as the epidermis portion.

In the present disclosure, the melting point of the solder is preferably, for example, 70°C or more and 140°C or less, and more preferably 80°C or more and 135°C or less. When the melting point of the solder is higher than the above range, the heat-resistant layer using polyethylene resin described above may be deteriorate when the wire is connected to the solar cell element.

In order to make the melting point to be in such range, for example, a compound including Sn, In, Ag and Bi may be used as the solder.

### II. Structure of current collector sheet

In the current collector sheet in the present disclosure, for one resin film for a current collector sheet, at least one or more wire may be placed. In view of improving the conductivity of the current collector sheet, a plurality of wires are preferably placed for one resin film for a current collector sheet.

When the current collector sheet includes a plurality of wires, the arrangement of the wires in a plan view may be similar to the arrangement of the wires in a well-known current collector sheet, and is not particularly limited. As the arrangement of the wires, the wires may be place in a line pattern, as shown in FIG. 3A for example, and although not shown in the figures, the wires may be placed in a lattice pattern.

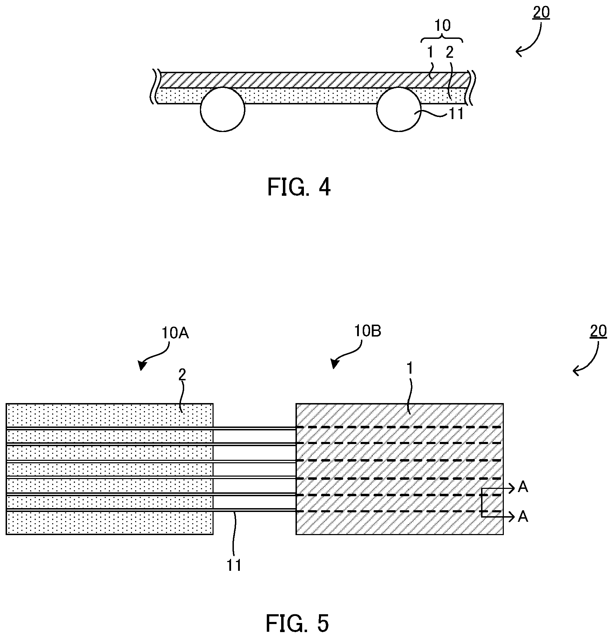

Also, in the current collector sheet, the wire is placed on the sealing layer side of the resin film for a current collector sheet. In the present disclosure, as shown in FIG. 3B for example, the wire 11 is preferably placed so that a part thereof is embedded in the sealing layer 2 of the resin film for a current collector sheet 10, and a part of the wire is exposed. The reason therefor is to preferably fix the wire 11. Also, as shown in FIG. 3B for example, the wire 11 may be embedded in the sealing layer 2 so as not to be in contact with the heat-resistant layer 1; and as shown in FIG. 4 for example, the wire 11 may be embedded in the sealing layer 2 so as to be in contact with the heat-resistant layer 1. When the wire is embedded in the sealing layer so as to be in contact with the heat-resistant layer, the thickness of the current collector sheet may be made thinner, so that the solar cell to be described later, may be made thinner. The degree of embedding of the wire (the degree of exposure of the wire) is not particularly limited, and may be appropriately selected according to the material or thickness of the sealing layer; the thickness of the wire; and the embodiment of the solar cell element in which the current collector sheet is placed.

In the present disclosure, for example, an identical wire may be placed on a plurality of the resin film for a current collector sheet. For example, in the example shown in FIG. 5, an identical wire 11 is placed on two resin film for a current collector sheet 10A and resin film for a current collector sheet 10B. Also, as shown in FIG. 5, adjacent resin films for a current collector sheet may be placed so that each sealing layer side surface are facing opposite surface direction to each other. That is, the sealing layer 2 side surface of one resin film for a current collector sheet 10A and the heat-resistant layer 1 side surface of the other resin film for a current collector sheet 10B may be placed in the identical surface direction. As shown in FIG. 6A for example, when the current collector sheet has the structure described above, the current collector sheet 10 allows two solar cell elements 31 to be arranged in series. Incidentally, although not shown in the figures, the current collector sheets may be placed so that both of the sealing layer side surfaces are facing the identical surface direction.

### III. Method for producing

The method for producing a current collector sheet is not particularly limited as long as it is capable of embedding the wire into the sealing layer side surface of the resin film for a current collector sheet to the extent that the wire may be fixed, and known methods may be used. Examples of the method may include a method wherein a wire is installed on the sealing layer side surface of the resin film for a current collector sheet, and by heating the wire, a part of the resin component in the sealing layer is melted and the wire is embedded.

### C. Solar cell element with current collector sheet

The solar cell element with a current collector sheet in the present disclosure is characterized in that it comprises the current collector sheet described in "B. Current collector sheet" above; and a solar cell element placed on a sealing layer side surface of the current collector sheet, and electrically connected to the wire.

The solar cell element with a current collector sheet in the present disclosure is explained referring to the figures. FIG. 6A is a schematic perspective view illustrating an example of a solar cell element with a current collector sheet in the present disclosure; FIG. 6B is an A-A line cross-sectional view of FIG. 6A; and FIG. 6C is a B-B line cross-sectional view of FIG. 6A. The solar cell element with a current collector sheet 30 shown in FIGS. 6A to 6C comprises the current collector sheet 10; and a solar cell element 31 placed on the sealing layer 2 side surface of the current collector sheet 10, and electrically connected to the wire 11. FIGS. 6A to 6C show an example wherein the current collector sheet 20 includes two resin films for a current collector sheet 10, and the solar cell element 31 is placed on respective resin films for a current collector sheet 10.

According to the present disclosure, by including the current collector sheet in the present disclosure described in "B. Current collector sheet" above, the light utilization efficiency of the solar cell element may be improved.

### I. Structure of solar cell element with current collector sheet

The solar cell element with a current collector sheet includes the current collector sheet and the solar cell element.

### 1. Current collector sheet

Since the current collector sheet may be similar to the contents described in the section "B. Current collector sheet" above, the explanation is omitted herein. In the present disclosure, when the solar cell element with a current collector sheet includes a plurality of the current collector sheet, at least one of the current collector sheets may be the current collector sheet in the present disclosure, and other current collector sheet may be included. In the present disclosure, all current collector sheets are preferably the current collector sheet in the present disclosure. Also, the current collector sheet in the present disclosure is preferably placed so that it is on the light-receptive surface side, when used in a solar cell.

### 2. Solar cell element

The solar cell element may be similar to the element used for a commonly used solar cell. Examples of the solar cell element may include a monocrystalline silicon type solar cell element, a polycrystalline silicon type solar cell element, an amorphous silicon type solar cell element, a compound semiconductor type solar cell element, a dye-sensitized type solar cell element, a quantum dot type solar cell element and an organic thin-film type solar cell element. The size and shape of the solar cell element may be appropriately selected according to the use application of the solar cell.

### II. Structure of solar cell element with current collector sheet

The solar cell element with a current collector sheet usually includes a stacked structure wherein the current collector sheet and the solar cell element are stacked.

As shown in FIG. 6C for example, when viewed base on the placement surface of the current collector sheet of the solar cell element, in the solar cell element with a current collector sheet, in relation to the thickness of the resin film for a current collector sheet 10 in perpendicular direction D_{L} with respect to the placement surface, that is, the distance from the surface of the solar cell element 31 where the current collector sheet 20 is placed, to the surface of the heat-resistant layer 1, on the opposite side to the solar cell element 31, the region where the wire 11 is placed is preferably thicker (the distance is longer) than other regions. This is because, by having such stacked structure, the heat-resistant layer 1 is able to press the wire 11 to the solar cell element 31 side effectively so that defects such as poor contact of wire 11 to the solar cell element 31 may be prevented.

In this case, the ratio x/y between the maximum distance y of the wire 11 in the perpendicular direction D_{L} with respect to the placement surface, that is, the maximum distance y of the wire 11 from the surface of the solar cell element 31 where the current collector sheet 20 is placed; and the minimum distance x of the sealing layer 2 in perpendicular direction D_{L} to the placement surface, that is, the minimum distance x among the distance from the surface of the solar cell element 31 where the current collector sheet 20 is placed, to the surface of the heat-resistant layer 1, on the opposite side to the solar cell element 31 is preferably 2/3 or less, and more preferably 1/2 or less.

Incidentally, the lower limit of the ratio x/y is a value appropriately adjusted according to the thickness of the sealing layer in the current collector sheet and the thickness of the wire, and is, for example, 1/20 or more. By the ratio x/y being in the above range, the wire may be fixed well to the solar cell element by using the resin film for a current collector sheet of the current collector sheet.

Such a ratio x/y may be obtained by adjusting the thickness (diameter and so on) of the wire and the thickness of the sealing layer described above. It may also be obtained by adjusting the pressure at the time of thermal compression bonding the current collector sheet to the solar cell element in the method for producing a solar cell element with a current collector sheet, which will be described later.

Also, as shown in FIG. 6C for example, in the cross-sectional view of the solar cell element with a current collector sheet 30, the distance from the current collector sheet 20 side surface of the solar cell element 31, to the surface of the heat-resistant layer 1, on the opposite side to the solar cell element 31, preferably gradually decreases, from the position with the maximum distance y toward the position with the minimum distance x.

Also, when a plurality of wires are placed, as shown in FIG. 6C for example, in the cross-sectional view of the solar cell element with a current collector sheet 30, a part with the minimum distance among the distance from the surface of the solar cell element 31 where the current collector sheet 20 is placed, to the surface of the heat-resistant layer 1, on the opposite side to the solar cell element 31, is preferably placed between adjacent wires. A concave is formed between the wires so that the current collector sheet has a structure with a convexo-concave shape. Therefore, the surface area of the surface of the heat-resistant layer, on the opposite side to the solar cell element is increased. Therefore, the contact area between the heat-resistant layer and the sealing material, which will be described later, is increased so that the close adhesiveness with the sealing material may be improved.

Also, as described in the section "B. Current collector sheet" above, in the solar cell element with a current collector sheet, the wire 11 may be embedded in the sealing layer 2 so as to be in contact with the heat-resistant layer 1, as shown in FIG. 6C for example. As the result, the thickness of the solar cell element with a current collector sheet may be made thinner, so that the solar cell may be made thinner.

The solar cell element with a current collector sheet is not particularly limited as long as it includes at least one solar cell element and a current collector sheet connected to at least one electrode of a cathode and an anode of the solar cell element. For example, it may be a solar cell element with a current collector sheet constituting a single cell type solar cell wherein a current collector sheet is placed on each of the cathode and anode of one solar cell element. Also, for example, it may be a solar cell element with a current collector sheet constituting a solar cell module type solar cell (solar cell module) wherein a plurality of solar cell elements are connected in parallel or in series using a current collector sheet.

### III. Others

The method for producing a solar cell element with a current collector sheet in the present disclosure is not particularly limited as long as it is able to obtain a structure wherein the wire of the current collector sheet is electrically connected and fixed to the solar cell element. Examples thereof may include a method for producing comprising a temporary adhering step of temporarily adhering the current collector sheet to the solar cell element; and a fixing step of electrically connecting and fixing the wire of the current collector sheet to the solar cell element by thermal compression bonding the temporary adhered current collector sheet to the solar cell element. For the temporary adhering method or the thermal compression bonding method, known methods may be used, and examples thereof may include a vacuum heat lamination method. Also, the fixing step may be carried out at the same time as the integrating step wherein each member of the solar cell is stacked and integrated, for example, as described in the section "D. Solar cell" below.

The solar cell element with a current collector sheet is usually used as a member constituting the solar cell. Incidentally, when the solar cell element with a current collector sheet includes, for example, one solar cell element and a current collector sheet connected to only one of the electrodes of the cathode and anode of the solar cell element, the solar cell element with a current collector sheet may be used as a part of, for example, the single cell type solar cell or solar cell element with a current collector sheet constituting the solar cell module described above.

### D. Solar cell

The solar cell in the present disclosure comprises a transparent substrate, a first sealing material, a solar cell element with a current collector sheet, a second sealing material and counter substrate, the solar cell element with a current collector sheet is the solar cell element with a current collector sheet described above.

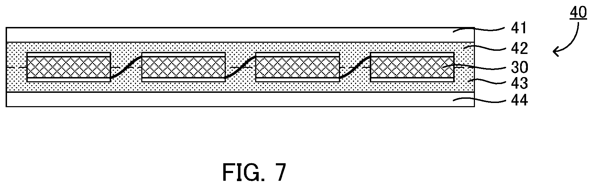

The solar cell in the present disclosure is explained referring to the figures. FIG. 7 is a schematic cross-sectional view illustrating an example of a solar cell in the present disclosure. The solar cell 40 shown in FIG. 7 includes a transparent substrate 41, a first sealing material 42, the solar cell element with a current collector sheet 30, a second sealing material 43 and a counter substrate 44. Also, the solar cell element a current collector sheet 30 includes the current collector sheet described in "C. Solar cell element with a current collector sheet" described above.

The solar cell in the present disclosure may be used as a solar cell module including a plurality of the solar cell elements with a current collector sheet.

According to the present disclosure, since the current collector sheet with good ultraviolet transmittance and good ultraviolet resistance is placed, the solar cell is able to exhibit a high light utilization efficiency.

### I. Structure of solar cell

The solar cell in the present disclosure includes a transparent substrate, a first sealing material, the solar cell element with a current collector sheet, a second sealing material and a counter substrate.

### 1. Solar cell element with current collector sheet

Since the solar cell element with a current collector sheet may be similar to the contents described in the section "C. Solar cell element with a current collector sheet" above, the explanation is omitted herein.

### 2. Transparent substrate and counter substrate

The transparent substrate is a member configured to protect the solar cell element together with the counter substrate. Also, the transparent substrate is usually placed on the light-receptive surface side of the solar cell and functions as a front protective plate on the light-receptive surface side. The transparency of the transparent substrate is not particularly limited as long as it is to the extent that it does not interfere the power generation of the solar cell element. The transparent substrate may be similar to a transparent substrate used in a commonly used solar cell, so the explanation herein is omitted.

The counter substrate is a member configured to protect the solar cell element together with the transparent substrate described above. The counter substrate may or may not have a transparency. When the counter substrate has a transparency, the both surfaces of the solar cell may be used as a light-receptive surface for sunlight. As the counter substrate, the transparent substrate described above may be used. Also, the backside protective sheet for a solar cell may be used as the counter substrate.

### 3. First sealing material and second sealing material

The first sealing material is a member configured to seal the solar cell element together with the second sealing material. The first sealing material is usually placed on the light-receptive surface side of the solar cell.

The first sealing material includes thermoplastic resin. The thermoplastic resin used for the first sealing material may be similar to the thermoplastic resin used as the sealing material of general solar cells. For example, sealing material including various olefin resins such as polyethylene resin and ethylene-vinyl acetate copolymer (EVA) as the main component may be used. These resins being the main component means that the proportion of these resins, among all the resin components, is the highest.

In the present disclosure, it is preferable that the first sealing material practically includes no ultraviolet absorber.

In conventional solar cells, polyethylene terephthalate (PET) is used for the heat-resistant layer, and ultraviolet absorber is included in the first sealing material to prevent deterioration of PET due to ultraviolet rays. Therefore, the power generation efficiency in the ultraviolet light region, of such solar cells, was low.

Meanwhile, as described above, since the solar cell in the present disclosure uses the current collector sheet described in the section "C. Solar cell element with current collector sheet", the deterioration of the heat-resistant layer due to ultraviolet rays may be suppressed. Therefore, there is no need to include an ultraviolet absorber in the first sealing material, and by using the first sealing material practically including no ultraviolet absorber, the solar cell in the present disclosure is able to improve the power generation efficiency in the ultraviolet region, thereby improving the overall power generation efficiency.

As described above, the first sealing material in the present disclosure practically includes no ultraviolet absorber. Specifically, the content of the ultraviolet absorber in the first sealing material is preferably 3.0% by mass or less, more preferably 1.0% by mass or less, and further preferably 0.5% by mass or less.

The content of the ultraviolet absorber is measured, for example, by Fourier transform infrared spectroscopy (FTIR) .

The ultraviolet absorber may be similar to the ultraviolet absorber used for sealing material of general solar cells, and specifically, it refers to benzotriazole based, triazine based and benzophenone based, and the fact that the first sealing material practically includes no ultraviolet absorber refers to that it practically includes no ultraviolet absorber.

The second sealing material in the present disclosure is a member configured to seal the solar cell element together with the first sealing material. When the counter substrate described above has transparency, it is preferable that the second sealing material includes no ultraviolet absorber, similarly to the first sealing material.

The thickness of the first sealing material and the second sealing material are appropriately selected according to the type and size of the solar cell.

### II. Physical properties of solar cell

Since the solar cell in the present disclosure includes the current collector sheet with good ultraviolet transmittance and good ultraviolet resistance, ultraviolet rays may be willingly utilized. The solar cell in the present disclosure preferably has absorption sensitivity in the ultraviolet region, specifically, it preferably has absorption sensitivity in the range of 100 nm or more and 400 nm or less.

### III. Method for producing

The method for producing a solar cell in the present disclosure may be similar to the method for producing a commonly used solar cell. Examples of the method may include a method for producing including a stacked body forming step of forming a stacked body including a transparent substrate, a first sealing material, a solar cell element with a current collector sheet, a second sealing material and counter substrate stacked in this order; and an integrating step of obtaining a solar cell by integrating the stacked body by a heat treatment and a pressurizing treatment.

The heat treatment and pressurizing treatment may be similar to the treatments usually carried out during production of a solar cell, and it is not particularly limited. It is preferably, for example, a vacuum heat lamination method. The conditions of the vacuum heat lamination method are not particularly limited, and may be appropriately selected according to the size of the solar cell, the type of each member and so on. The lamination temperature is preferably, for example, 130°C or more and 170°C or less, the lamination time is preferably 5 minutes or more and 30 minutes or less, and more preferable 8 minutes or more and 15 minutes or less.

### IV. Use application

The solar cell in the present disclosure may be used for a variety of applications, for example, a solar cell for electronic devices or a large solar cell for outdoor installations.

Incidentally, the present disclosure is not limited to the embodiments. The embodiments are exemplification, and any other variations are intended to be included in the technical scope of the present disclosure if they have substantially the same constitution as the technical idea described in the claim of the present disclosure and offer similar operation and effect thereto.

### Examples

### [Examples 1 to 10]

Using the resin components and additives shown in Table 1 below, resin compositions for forming respective layers of a heat-resistant layer, and a substrate layer and an adhesive layer constituting a sealing layer were prepared. Using an extruder equipped with a T-die, the resin compositions described above were melted at 190°C and co-extruded to obtain a resin film for a current collector sheet wherein a heat-resistant layer, a substrate layer and an adhesive layer were stacked in this order. In relation to the resin film for a current collector sheet, the total thickness was 100 um, the thickness of the heat-resistant layer was 40 um, the thickness of the substrate layer was 30 um, and the thickness of the adhesive layer was 30 um.

### [Examples 11 to 20]

Using the resin components and additives shown in Table 1 below, resin compositions for forming respective layers of a heat-resistant layer, and a sealing layer were prepared. Using an extruder equipped with a T-die, the resin compositions described above were melted at 190°C and co-extruded to obtain a resin film for a current collector sheet wherein a heat-resistant layer and a sealing layer were stacked. In relation to the resin film for a current collector sheet, the total thickness was 100 um, the thickness of the heat-resistant layer was 40 um and the thickness of the sealing layer was 60 um.

### [Comparative Example 1]

A resin film for a current collector sheet was obtained in the same manner as in Example 1, except that, using the resin components and additives shown in Table 1 below, resin composition for forming respective layers of a heat-resistant layer, and a substrate layer and an adhesive layer constituting a sealing layer were prepared.

### [Comparative Example 2]

A PET film was prepared as a film constituting a heat-resistant layer, and an LDPE film was prepared as a film constituting a sealing layer, and a resin film for a current collector sheet was obtained by adhering the PET film and LDPE film by a dry lamination method using acrylic based adhesive.

### [Evaluation]

### (Ultraviolet transmittance)

Firstly, for Examples 1 to 20 and Comparative Example 1, a measurement sample was prepared by stacking a sealing material sheet including olefin resin ("CVF2SS" from Dai Nippon Printing Co., Ltd.) with a thickness of 450 um on the heat-resistant layer side surface of the resin film for a current collector sheet, vacuum laminating under the conditions of setting temperature of 150°C, vacuum evacuation for 5 minutes, pressurization at atmospheric pressure for 9 minutes and pressure of 100 kPa. Also, for Comparative Example 2, a measurement sample was prepared by stacking a sealing material sheet including olefin resin ("CVF" from Dai Nippon Printing Co., Ltd.) with a thickness of 450 um on the heat-resistant layer side surface of the resin film for a current collector sheet, vacuum laminating under the conditions of setting temperature of 150°C, vacuum evacuation for 5 minutes, pressurization at atmospheric pressure for 9 minutes and pressure of 100 kPa. Then, the transmittance of light, at the wavelength of 350 nm, of the measurement sample was measured by a spectrophotometer ("V-650" from JASCO Corporation).

### (Total light transmittance)

The total light transmittance of the obtained resin film for a current collector sheet was measured according to JIS K7361-1:1997 with a haze meter HM150 from Murakami Color Research Laboratory Co., Ltd.

### (Haze)

The obtained resin film for a current collector sheet was cut into a size of 50 mm × 50 mm to prepare a test piece. Then, an ETFE (tetrafluoroethylene-ethylene copolymer) film, the test piece, and an ETFE film were stacked in this order, and a vacuum lamination was carried out under conditions of setting temperature of 165°C, vacuum evacuation for 2 minutes, pressing for 2.5 minutes and pressure of 100 kPa. The ETFE films were then removed respectively from both surfaces of the test piece to obtain a measurement sample. The haze of the measurement sample was measured according to JIS K7136:2000 with a haze meter HM150 from Murakami Color Research Laboratory Co., Ltd.

### (Interlayer adhesive strength between heat-resistant layer and sealing layer (suitability for coextrusion film forming))

The obtained resin film for a current collector sheet was cut into a size of 15 mm width × 100 mm length to prepare a sample. A peeling test was carried out by imparting a trigger to peel off to the interface between the heat-resistant layer and the sealing layer of the obtained sample, and holding 10 mm of the top and bottom of a peeling tester (Tensilon Universal Material Testing Instrument RTF-1150-H from A & D Co. Ltd.) with jigs, and under the conditions of a distance between chucks of 30 mm and a pulling strength of 50 mm/min., so as to measure the interlayer adhesive strength between the heat-resistant layer and the sealing layer.

### (Storage elastic modulus of heat-resistant layer)

Firstly, the resin film for a current collector sheet was cut into a size of 5 mm × 20 mm, the sealing layer was scraped off from the resin film for a current collector sheet, to prepare a sample of the heat-resistant layer. Then, the storage elastic modulus of the heat-resistant layer was measured by dynamic mechanical analysis (DMA) by the method according to JIS K7244-4:1999. Specifically, both ends of the sample were installed to the chuck of the dynamic mechanical analysis device (Rheogel-E4000 from UBM Corporation) so that the tensile direction was the longitudinal direction of the sample, and the measurement was carried out by a tensile method under a tensile load and the following measurement conditions.

### <Measurement conditions of storage elastic modulus>

▪ Measurement sample: rectangle shape of 5 mm × 20 mm
▪ Measurement mode: tensile method (sine-wave distortion, tensile mode, strain amount: automatic strain)
▪ Temperature rising rate: 3°C/min
▪ Temperature: -60°C or more and 150°C or less
▪ Frequency: 10 Hz
▪ Tensile load (static load): 100 g

### (Light resistance test)

A test piece of the resin film for a current collector sheet cut into a size of 50 mm × 50 mm was inserted into a Super UV tester ("I Super UV Tester" from Iwasaki Electric Co., Ltd.), and the deterioration acceleration test was carried out for 168 hours under the irradiation condition of 100 mW/cm². After 168 hours, the appearance of the test piece was visually observed and the light resistance was evaluated.
A: no particular change in appearance
B: a minute crack occurred
C: a complete crack occurred in appearance

### (Heat shrinkage ratio)

On a test piece of the resin film for a current collector sheet cut into a size of 150 mm × 150 mm, a parallel cross lines were drawn so that the length was 100 mm, and then heated in an oven set at 150°C on talc for 10 minutes. Then, before and after heating, the distance inside the parallel cross lines was measured by a glass scale to determine the heat shrinkage ratio. Incidentally, in Comparative Examples 1 to 2, since the resin films for a current collector sheet were melted by heating, the measurement was not possible.

### (Curl Test)

The obtained resin film for a current collector sheet was cut into a size of 150 mm × 150 mm to prepare a sample. The sample was placed on a horizontal surface with the heat-resistant layer side surface facing downward, and the average value of the deviation distance from the horizontal surface, of each side of the test piece, was measured. When the average value of the deviation distance was less than 10 mm, it was evaluated as "A", and when the average value of the deviation distance was more than 40 mm, it was evaluated as "B".

**[Table 1]**

| Layer | | Model No. | Type | Ex. 1 | Ex. 2 | Ex. 3 | Ex. 4 | Ex. 5 | Ex. 6 | Ex. 7 | Ex. 8 | Ex. 9 | Ex. 10 | Comp. Ex. 1 | Comp. Ex. 2 |
|---|---|---|---|---|---|---|---|---|---|---|---|---|---|---|---|
| | | Heat-resistant layer S135 | Homo PP | 67.3 | 67.3 | 67.3 | | | 67.3 | 67.3 | | 76.9 | 76.9 | | PET |
| | | S235 | Random PP | | | | 67.3 | 67.3 | | | 67.3 | 19.2 | | | |
| | | PN3560 | PP based elastomer | 19.2 | 9.6 | | | 19.2 | 9.6 | | | | | | |
| | | PN0040 | PP based elastomer | | | 19.2 | 9.6 | | | 19.2 | 10 | | 19.2 | | |
| | | DF110 | PE-α-olefin copolymer | 9.6 | 19.2 | 9.6 | 19.2 | | | | | | | 96 | |
| | | A4090S | PE-α-olefin copolymer | | | | | 9.6 | 19.2 | 9.6 | 20 | | | 0 | |
| | | XJ100H | Wx. resis. Agt. (HALS) | 3.9 | 3.9 | 3.9 | 3.9 | 3.9 | 3.9 | 3.9 | 4 | 3.9 | 3.9 | 4 | |
| Sealing layer | Sub-strate layer | KF260T | PE-α-olefin copolymer | 99 | 99 | 99 | 99 | 99 | 99 | 99 | 99 | 99 | 99 | 99 | LDPE |
| | | XJ100H | Wx. resis. Agt. (HALS) | 1 | 1 | 1 | 1 | 1 | 1 | 1 | 1 | 1 | 1 | 1 | |
| | Adh. layer | KF260T | PE-α-olefin copolymer | 84.1 | 84.1 | 84.1 | 84.1 | 84.1 | 84.1 | 84.1 | 84.1 | 84.1 | 84.1 | 84.1 | |
| | | MF900N | Silane-mod. PE resin | 14.9 | 14.9 | 14.9 | 14.9 | 14.9 | 14.9 | 14.9 | 14.9 | 14.9 | 14.9 | 14.9 | |
| | | XJ100H | Wx. resis. Agt. (HALS) | 1 | 1 | 1 | 1 | 1 | 1 | 1 | 1 | 1 | 1 | 1 | |
| Transmittance of 350 nm wl. It. (%) | | | | 88.9 | 88.6 | 89.0 | 88.6 | 88.5 | 88.5 | 88.5 | 88.6 | 88.5 | 88.4 | 89.0 | <5 |
| Total light transmittance (%) | | | | 90.9 | 90.9 | 90.9 | 90.9 | 90.9 | 90.9 | 90.9 | 90.9 | 90.9 | 90.9 | 91.0 | 90.8 |
| HAZE(%) | | | | 5.4 | 5.0 | 5.3 | 4.9 | 5.4 | 5.1 | 5.2 | 5.1 | 5.8 | 5.4 | 4.9 | 10.0 |
| Interlayer adh. Str. of heat-resistant layer and sealing layer (N/15mm) | | | | 2.5 | 5.0 | 2.0 | 6.8 | 1.1 | 5.0 | 2.9 | 5.3 | 1.0 | 2.0 | 5.2 | 5.0 |
| Storage elastic modulus of heat-resistant layer (MPa) | | | | 1.2×10⁷ | 1.2×10⁷ | 1.2×10⁷ | 1.2×10⁷ | 1.2×10⁷ | 1.2×10⁷ | 1.2×10⁷ | 1.2×10⁷ | 1.2×10⁷ | 1.2×10⁷ | 1.0×10⁴ | 2.0×10⁸ |
| Heat shrinkage ratio (%) | | | | 2.4 | 2.1 | 1.9 | 1.7 | 2.5 | 2.3 | 2.1 | 2 | 1.2 | 1.3 | Unmeasurable | 2.1 |
| Light resistance test | | | | A | A | A | A | A | A | A | A | B | B | A | C |
| Curl test | | | | A | A | A | A | A | A | A | A | A | A | B | B |

**[Table 2]**

| Layer | Model No. | Type | Ex. 11 | Ex. 12 | Ex. 13 | Ex. 14 | Ex. 15 | Ex. 16 | Ex. 17 | Ex. 18 | Ex. 19 | Ex. 20 |
|---|---|---|---|---|---|---|---|---|---|---|---|---|
| Heat-rstn. layer | S135 | Homo PP | 67.3 | 67.3 | 67.3 | 67.3 | 67.3 | 67.3 | 67.3 | 67.3 | 76.9 | 76.9 |
| | PN3560 | PP based elastomer | 19.2 | 9.6 | | | 19.2 | 9.6 | | | 19.2 | |
| | PN0040 | PP based elastomer | | | 19.2 | 9.6 | | | 19.2 | 10 | | 19.2 |
| | DF110 | PE-α-olefin copolymer | 9.6 | 19.2 | 9.6 | 19.2 | | | | | | |
| | A4090S | PE-α-olefin copolymer h | | | | | 9.6 | 19.2 | 9.6 | 20 | | |
| | XJ100H | Wx. resis. Agt. (HALS) | 3.9 | 3.9 | 3.9 | 3.9 | 3.9 | 3.9 | 3.9 | 4 | 3.9 | 3.9 |
| | Sealing layer KF260T | PE-α-olefin copolymer | 84 | 84 | 84 | 84 | 84 | 84 | 84 | 84 | 84 | 84 |
| | MF900N | Silane-mod. PE resin | 15 | 15 | 15 | 15 | 15 | 15 | 15 | 15 | 15 | 15 |
| | XJ100H | Wx. resis. Agt. (HALS) | 1 | 1 | 1 | 1 | 1 | 1 | 1 | 1 | 1 | 1 |
| Transmittance of 350 nm wl. It. (%) | | | 88.9 | 88.6 | 89.0 | 88.6 | 88.5 | 88.5 | 88.5 | 88.6 | 88.5 | 88.4 |
| Total light transmittance (%) | | | 90.9 | 90.9 | 90.9 | 90.9 | 90.9 | 90.9 | 90.9 | 90.9 | 90.9 | 90.9 |
| HAZE(%) | | | 5.4 | 5.0 | 5.3 | 4.9 | 5.4 | 5.1 | 5.2 | 5.1 | 5.8 | 5.4 |
| Interlayer adh. str. of heat-rstn. layer and sealing layer (N/15mm) | | | 2.5 | 5.0 | 2.0 | 6.8 | 1.1 | 5.0 | 2.9 | 5.3 | 1.0 | 2.0 |
| Storage elastic modulus of heat-resistant layer (MPa) | | | 1.2×10⁷ | 1.2×10⁷ | 1.2×10⁷ | 1.2×10⁷ | 1.2×10⁷ | 1.2×10⁷ | 1.2×10⁷ | 1.2×10⁷ | 1.2×10⁷ | 1.2×10⁷ |
| Heat shrinkage ratio (%) | | | 2.4 | 2.1 | 1.9 | 1.7 | 2.5 | 2.3 | 2.1 | 2 | 1.2 | 1.3 |
| Light resistance test | | | A | A | A | A | A | A | A | A | B | B |
| Curl test | | | A | A | A | A | A | A | A | A | A | A |

Incidentally, in Table 1 and Table 2, "S135" refers to S135 (trade name) from Prime Polymer Co., Ltd. (density of 0.9 g/cm3, melting point of 165°C, MFR (190°C) of 4.0 g/10 min); "S235" refers to S235 (trade name) from Prime Polymer Co., Ltd. (density of 0.900 g/cm3, melting point of 135°C, MFR (230°C) of 10 g/10 min); "PN3560" refers to TAFMER PN3560 (trade name) from Mitsui Chemicals, Inc. (density of 0.866 g/cm3, melting point of 160°C) MFR (190°C) of 2.8 g/10 min); "PN0040" refers to TAFMER PN0040 (trade name) from Mitsui Chemicals, Inc. (density of 0.868 g/cm3, melting point of 160°C, MFR (190°C) of 2.0 g/10 min); "DF110" refers to TAFMER DF110 (trade name) from Mitsui Chemicals, Inc. (density of 0.905 g/cm³, melting point of 94°C, MFR (190°C) of 1.2 g/10 min); "A4090S" refers to TAFMER A4090S (trade name) from Mitsui Chemicals, Inc. (density of 0.893 g/cm3, melting point of 77°C, MFR (190°C) of 3.6 g/10 min); "XJ100H" refers to XJ-100X (trade name) from Japan Polyethylene Corporation (density of 0.93 g/cm3, melting point of 115°C, MFR (190°C) of 3.0 g/10 min); "KF260T" refers to Metallocene Polyethylene KN KF260T (trade name) from Japan Polyethylene Corporation (density of 0.9 g/cm3, melting point of 93°C, MFR (190°C of 2.0 g/10 min); and "MF900N" refers to Linklon MF900N (trade name) from Mitsubishi Chemical Corporation (density of 0.9 g/cm³, melting point of 83°C, MFR(190°C) of 1.0 g/10 min).

From the results of Examples 1 to 20, it was confirmed that, by compounding polypropylene resin in the heat-resistant layer of the resin film for a current collector sheet, it is possible to obtain a resin film for a current collector sheet with good ultraviolet transmittance and with little appearance deterioration even after the light resistance test.

That is, the present disclosure is able to provide the following inventions.
[1] A resin film for a current collector sheet to be used for a current collector sheet of a solar cell, the resin film for a current collector sheet comprising: a heat-resistant layer and a sealing layer placed on one surface side of the heat-resistant layer, wherein the heat-resistant layer includes polypropylene resin.
[2] The resin film for a current collector sheet according to [1], wherein the heat-resistant layer includes a light stabilizer.
[3] The resin film for a current collector sheet according to [1] or [2], wherein a melting point of resin used for the heat-resistant layer is 80°C or more and 200°C or less.
[4] The resin film for a current collector sheet according to any one of [1] to [3], wherein a storage elastic modulus of the heat-resistant layer at 150°C is 0.1 MPa or more and 1.0 GPa or less.
[5] The resin film for a current collector sheet according to any one of [1] to [4], wherein the polypropylene resin is homopolypropylene resin.
[6] The resin film for a current collector sheet according to any one of [1] to [5], wherein the heat-resistant layer includes at least any one of polyethylene based elastomer and polyethylene based plastomer.
[7] The resin film for a current collector sheet according to any one of [1] to [6], wherein the sealing layer includes polyolefin resin with a melting point of 80°C or more and 125°C or less.
[8] The resin film for a current collector sheet according to [7], wherein the polyolefin resin is polyethylene resin.
[9] The resin film for a current collector sheet according to [8], wherein the sealing layer includes silane-modified polyethylene resin.
[10] A current collector sheet to be used for a solar cell, the current collector sheet comprising: the resin film for a current collector sheet according to any one of [1] to [9]; and a wire placed on a sealing layer side surface of the resin film for a current collector sheet.
[11] A solar cell element with a current collector sheet comprising: the current collector sheet according to [10]; and a solar cell element placed on a sealing layer side surface of the current collector sheet, and electrically connected to the wire.
[12] The solar cell element with a current collector sheet according to [11], wherein a minimum distance among a distance from a surface of the solar cell element where the current collector sheet is placed, to a surface of the heat-resistant layer, on a opposite side to the solar cell element is 2/3 or less of a maximum distance of the wire, from a surface of the solar cell element where the current collector sheet is placed.
[13] The solar cell element with a current collector sheet according to [12], wherein a plurality of the wires are included, and in a cross-sectional view of the solar cell element with a current collector sheet, a part with the minimum distance among the distance from the surface of the solar cell element where the current collector sheet is placed, to the surface of the heat-resistant layer, on a opposite side to the solar cell element, is located between adjacent wires.
[14] The solar cell element with a current collector sheet according to any one of [11] to [13], wherein the wire is in contact with the heat-resistant layer.
[15] A solar cell comprising a transparent substrate, a first sealing material, the solar cell element with a current collector sheet according to any one of [11] to [14], a second sealing material and counter substrate in this order.
[16] The solar cell according to [15], wherein content of an ultraviolet absorber in the first sealing material is 3.0% by mass or less.
[17] The solar cell according to [15] or [16] wherein the solar cell is a solar cell module including a plurality of the solar cell elements with a current collector sheet.

### Reference Signs List

1: heat-resistant layer
2: sealing layer
2a: substrate layer
2b: adhesive layer
10, 10A, 10B: resin film for a current collector sheet
11: wire
20: current collector sheet
30: solar cell element with a current collector sheet
31: solar cell element
40: solar cell
41: transparent substrate
42: first sealing material
43: second sealing material
44: counter substrate

## Claims

1. A resin film for a current collector sheet to be used for a current collector sheet of a solar cell, the resin film for a current collector sheet comprising:
a heat-resistant layer and a sealing layer placed on one surface side of the heat-resistant layer,
wherein the heat-resistant layer includes polypropylene resin.

2. The resin film for a current collector sheet according to claim 1, wherein the heat-resistant layer includes a light stabilizer.

3. The resin film for a current collector sheet according to claim 1, wherein a melting point of resin used for the heat-resistant layer is 80°C or more and 200°C or less.

4. The resin film for a current collector sheet according to claim 1, wherein a storage elastic modulus of the heat-resistant layer at 150°C is 0.1 MPa or more and 1.0 GPa or less.

5. The resin film for a current collector sheet according to claim 1, wherein the polypropylene resin is homopolypropylene resin.

6. The resin film for a current collector sheet according to claim 1, wherein the heat-resistant layer includes at least any one of polyethylene based elastomer and polyethylene based plastomer.

7. The resin film for a current collector sheet according to claim 1, wherein the sealing layer includes polyolefin resin with a melting point of 80°C or more and 125°C or less.

8. The resin film for a current collector sheet according to claim 7, wherein the polyolefin resin is polyethylene resin.

9. The resin film for a current collector sheet according to claim 8, wherein the sealing layer includes silane-modified polyethylene resin.

10. A current collector sheet to be used for a solar cell, the current collector sheet comprising:
the resin film for a current collector sheet according to any one of claims 1 to 9; and
a wire placed on a sealing layer side surface of the resin film for a current collector sheet.

11. A solar cell element with a current collector sheet comprising: the current collector sheet according to claim 10; and a solar cell element placed on a sealing layer side surface of the current collector sheet, and electrically connected to the wire.

12. The solar cell element with a current collector sheet according to claim 11, wherein a minimum distance among a distance from a surface of the solar cell element where the current collector sheet is placed, to a surface of the heat-resistant layer, on a opposite side to the solar cell element is 2/3 or less of a maximum distance of the wire, from a surface of the solar cell element where the current collector sheet is placed.

13. The solar cell element with a current collector sheet according to claim 12, wherein a plurality of the wires are included, and
in a cross-sectional view of the solar cell element with a current collector sheet, a part with the minimum distance among the distance from the surface of the solar cell element where the current collector sheet is placed, to the surface of the heat-resistant layer, on a opposite side to the solar cell element, is located between adjacent wires.

14. The solar cell element with a current collector sheet according to claim 11, wherein the wire is in contact with the heat-resistant layer.

15. A solar cell comprising a transparent substrate, a first sealing material, the solar cell element with a current collector sheet according to claim 11, a second sealing material and counter substrate in this order.

16. The solar cell according to claim 15, wherein content of an ultraviolet absorber in the first sealing material is 3.0% by mass or less.

17. The solar cell according to claim 15, wherein the solar cell is a solar cell module including a plurality of the solar cell elements with a current collector sheet.
